# EUROPÄISCHE PATENTANMELDUNG

(11) **EP 3 130 970 A1**
(43) Veröffentlichungstag der Anmeldung: **15.02.2017**
(21) Anmeldenummer: 15180733.6
(22) Anmeldetag: 12.08.2015
(51) Int. Cl.: G05B 19/042, G01R 31/3183, G05B 23/02, G06F 17/50, G01R 31/02

(54) **VERFAHREN ZUM VERBINDEN EINER EINGABE/AUSGABE-SCHNITTSTELLE EINES FÜR DIE STEUERGERÄTENTWICKLUNG EINGERICHTETEN TESTGERÄTS**

(71) Anmelder: dSPACE digital signal processing and control engineering GmbH, 33102 Paderborn (DE)
(72) Erfinder: Naundorf, Holger, 33104 Paderborn (DE)

(57) **Zusammenfassung**

Ein Verfahren zum Verbinden einer Eingabe/Ausgabe-Schnittstelle (4) eines Testgeräts (2) mit einem im Testgerät vorhandenen Modell (8) eines technischen Systems unter Verwendung eines bereits vorhandenen Basistestmodells (100) eines Steuergeräts wird vorgeschlagen. Dabei ist die Schnittstelle zum Anschluss einer gerätemäßigen Implementierung (200) des Steuergeräts oder zum Anschluss eines zu steuernden technischen Systems ausgebildet, und das Modell ist ein Testmodell (8) des technischen Systems oder ein Testmodell des Steuergeräts. Das Verfahren weist die folgenden Schritte auf: Zugreifen auf das Basistestmodell, wobei das Basistestmodell für einen rein rechnergestützten Basistest ausgelegt ist, Extrahieren von Kommunikationsanforderungen aus dem Basistestmodell, auf der Basis der Kommunikationsanforderungen, Festlegen von Merkmalen einer für die Kommunikationsanforderung geeignete physikalischen Signalübertragung, und Konfigurieren von Verbindungen (6) zwischen der Schnittstelle des Testgeräts und dem Modell, die die physikalische Signalübertragung über die Schnittstelle gemäß den Merkmalen ermöglicht.

## Beschreibung

Die vorliegende Erfindung betrifft die Entwicklung von Steuergeräten, wie sie z. B. in der Automobilindustrie oder in der Luftfahrtindustrie zur Steuerung von technischen Systemen, wie z. B. Motoren oder Bremsen, verwendet werden. Insbesondere betrifft die vorliegende Erfindung Testgeräte, die im Entwicklungsprozess des Steuergeräts verwendet werden.

Die Entwicklung von Steuergeräten ist zu einem hochkomplexen Prozess geworden. So sollen neue Steuergeräte bzw. neue Steuerfunktionen so früh wie möglich im Entwicklungsprozess getestet werden, um die generelle Funktionalität zu überprüfen und die weitere Entwicklungsrichtung vorzugeben. Gegen Ende des Entwicklungsprozesses ist es wichtig, das schon weit entwickelte Steuergerät möglichst umfassend zu testen, um aufgrund der Testergebnisse notwendige Modifikationen vorzunehmen, bevor das Steuergerät in Benutzung bzw. in Serienfertigung geht, so dass es im späteren Betrieb unter allen Umständen wie gewünscht arbeitet.

Drei beispielhafte Schritte des Entwicklungsprozesses werden nachfolgend beschrieben. In zwei dieser beispielhaften Entwicklungsphasen kommen Testgeräte zum Einsatz, während die dritte beschriebene Entwicklungsphase rein rechnergestützt abläuft.

Zu einem recht späten Stadium des Entwicklungsprozesses kommen sog. Hardware-in-the-Loop-Simulatoren (HIL-Simulatoren) zum Einsatz. Solche HIL-Simulatoren enthalten ein Modell des zu steuernden technischen Systems, wobei das Modell in Software vorliegt. Der HIL-Simulator enthält weiterhin eine Eingabe/Ausgabe-Schnittstelle, an die das schon weit entwickelte, bereits in Hardware gegenständlich vorhandene Steuergerät, auch als gerätemäßige Implementierung des Steuergeräts bezeichnet, angeschlossen werden kann. In verschiedenen Simulationsdurchläufen kann nun die Funktionalität des Steuergeräts getestet werden, wobei die Reaktionen des Modells des zu steuernden technischen Systems auf die Signale des Steuergeräts sowie die Reaktionen des Steuergeräts auf von dem Modell des zu steuernden technischen Systems vorgegebene Ereignisse beobachtet werden können. Dabei können sowohl der normale Betrieb als auch Fehler in dem zu steuernden technischen System als auch Fehler in dem Steuergerät als auch Fehler in der Kommunikation zwischen Steuergerät und zu steuerndem System, wie z.B. Kabelbrücke, als auch Fehler in der Stromversorgung, wie z.B. Kurzschlüsse, simuliert werden.

Demgegenüber ist das sogenannte Rapid Control Prototyping (RCP) ein Entwicklungsschritt, der mehr am Anfang des Entwicklungsprozesses steht. Beim RCP kommt das Testgerät auf Seiten des Steuergeräts zum Einsatz. Das Testgerät enthält ein Testmodell des Steuergeräts. Aufgrund des frühen Entwicklungsstadiums ist das Testmodell des Steuergeräts noch recht rudimentär im Vergleich zu dem späteren finalen Steuergerät. Auch ist normalerweise noch keine Hardware-Implementierung des Steuergeräts vorhanden, vielmehr ist das in dem Testgerät vorhandene Testmodell des Steuergeräts ein Software-Modell. Das Testgerät kann über eine Eingabe/Ausgabe-Schnittstelle mit dem zu steuernden technischen System selbst oder mit dem bisher vorhandenen Steuergerät für das zu steuernde technische System verbunden werden. Im ersten Fall besteht eine direkte Verbindung zwischen dem zu testenden Steuergerät, in der Form eines Software-Modells, und dem gegenständlich vorhandenen, zu steuernden technischen System. Im zweiten Fall ist das bisher vorhandene Steuergerät das durch das RCP-Testgerät zu steuernde technische System. Diese Steuerung des bisher vorhandenen Steuergeräts führt zu einer Modifikation der Steuerverfahren des bisher vorhandenen Steuergeräts, wodurch neue Steuer-Funktionalität mittels des von außen angeschlossenen RCP-Testgeräts getestet werden kann. Dieser Vorgang kann auch als "Bypassing" bezeichnet werden.

In einer noch früheren Phase der Steuergerätentwicklung kann die grundlegende Funktionalität von Steuer- und Regelungsverfahren rein rechnergestützt evaluiert werden. Zu diesem Zweck wird ein Basistestmodell des Steuergeräts in Software erstellt, das ohne Einbettung in ein Testgerät und ohne physikalische Anbindung an das zusteuernde technische System getestet werden kann. Der Test kann in dieser Phase so durchgeführt werden, dass das Verhalten des Basistestmodells als solches, d.h. die internen Zustände des Basistestmodells, oder das Verhalten des Basistestmodells im Zusammenspiel mit einem rechnergestützten Modell der späteren Umgebung des Steuergeräts beobachtet und evaluiert wird. Für die Erstellung von Basistestmodellen von Steuergeräten und von den genannten Modellen der Umgebung der Steuergeräte gibt es rechnergestützte Entwicklungsumgebungen, wie z.B. Simulink ®. Solche Entwicklungsumgebungen erlauben auch ein Testen der Basistestmodelle in der modellierten Umgebung. Für detaillierte Tests von Basistestmodellen in modellierten Umgebungen gibt es wiederum spezialisierte Produkte, wie z.B. VEOS ®. Die genannten Basistestmodelle von Steuergeräten werden auch als virtuelle Steuergeräte, sogenannte "Virtual Electronic Control Units" (V-ECUs) bezeichnet, insbesondere im Bereich der Steuergerätentwicklung in der Automobilindustrie. Neben dem Testen der grundlegenden Funktionalität von Steuer- und Regelungsverfahren in einer frühen Phase der Steuergerätentwicklung können Basistestmodelle auch dazu verwendet werden, gewisse Tests von HIL-Simulationen vorzuverlagern und so den Testumfang während der HIL-Testphase gering zu halten.

In den beiden erstgenannten Beispielen der Steuergerätentwicklung, nämlich HIL-Simulator und RCP-Testgerät, gibt es ein Testgerät, in dem ein Modell vorhanden ist und welches über die Eingabe/Ausgabe-Schnittstelle mit einem externen Gerät verbunden werden muss, so dass der Test durchgeführt werden kann. In dem Fall von RCP enthält das Testgerät ein Testmodell des Steuergeräts und wird mit dem zu steuernden technischen System verbunden. In dem Fall von HIL enthält das Testgerät ein Testmodell des zu steuernden technischen Systems und wird mit einer gerätemäßigen Implementierung des Steuergeräts verbunden. In beiden Fällen wird ein für die Steuergerätentwicklung eingerichtetes Testgerät bereitgestellt, wobei einmal das Steuergerät als Testmodell getestet wird und einmal das Steuergerät als extern anschließbare Hardware-Implementierung getestet wird.

Wie bereits angedeutet, verfügt das Testgerät in beiden Fällen über eine Eingabe/Ausgabe-Schnittstelle, über die das Testgerät, je nach Anwendungsfall, mit dem zu steuernden technischen System bzw. mit dem zu testenden, gerätemäßig implementierten Steuergerät verbunden wird. Diese Eingabe/Ausgabe-Schnittstelle wird in dem Testgerät mit dem in dem Testgerät vorhandenen Modell verbunden, so dass das Modell über die Eingabe/Ausgabe-Schnittstelle mit dem zu steuernden technischen System bzw. mit dem zu testenden Steuergerät kommunizieren kann.

Ein und dasselbe Testgerät kann für verschiedene Simulationen verwendet werden. In anderen Worten, ein und dasselbe Testgerät kann mit verschiedenen in dem Testgerät vorhandenen Modellen und mit verschiedenen an das Testgerät angeschlossenen zu testenden Steuergeräten bzw. zu steuernden technischen Systemen verwendet werden. Es ist ersichtlich, dass für verschiedene angeschlossene Geräte/Systeme und für verschiedene Modelle unterschiedliche Kanäle der Eingabe/Ausgabe-Schnittstelle und unterschiedliche Ansteuerungen der Eingabe/Ausgabe-Schnittstelle erforderlich sind. Dementsprechend ist es üblich, vor der Durchführung einer bestimmten Simulation bestimmte Verbindungen zwischen der Eingabe/Ausgabe-Schnittstelle auf der einen Seite und dem in dem Testgerät vorhandenen Modell auf der anderen Seite zu erzeugen. Dieser Prozess der Konfiguration von Verbindungen zwischen der Eingabe/Ausgabe-Schnittstelle und dem in dem Testgerät vorhandenen Modell ist aufwändig. Bisher gibt es kein Verfahren, das eine zufriedenstellende Unterstützung für diesen Prozess bietet.

Demzufolge wäre es vorteilhaft, ein verbessertes Verfahren zum Verbinden der Eingabe/Ausgabe-Schnittstelle eines für die Steuergerätentwicklung eingerichteten Testgeräts mit einem in dem Testgerät vorhandenen Modell eines technischen Systems zu ermöglichen.

Beispielhafte Ausführungsformen der Erfindung umfassen ein Verfahren zum Verbinden einer Eingabe/Ausgabe-Schnittstelle eines für die Steuergerätentwicklung eingerichteten Testgeräts mit einem in dem Testgerät vorhandenen Modell eines technischen Systems unter Verwendung eines bereits vorhandenen Basistestmodells eines Steuergeräts, wobei die Eingabe/Ausgabe-Schnittstelle zum Anschluss einer gerätemäßigen Implementierung des Steuergeräts oder zum Anschluss eines zu steuernden technischen Systems ausgebildet ist und das mit der Eingabe/Ausgabe-Schnittstelle zu verbindende Modell ein Testmodell des zu steuernden technischen Systems oder ein Testmodell des Steuergeräts ist. Dabei weist das Verfahren die folgenden Schritte auf: Zugreifen auf das bereits vorhandene Basistestmodell des Steuergeräts, wobei das Basistestmodell für einen rein rechnergestützten Basistest ausgelegt ist; Extrahieren von mindestens einer Kommunikationsanforderung aus dem Basistestmodell des Steuergeräts; auf der Basis der mindestens einen Kommunikationsanforderung, Festlegen von mindestens einem Merkmal einer physikalischen Signalübertragung, die für die Kommunikationsanforderung geeignet ist; und Konfigurieren von mindestens einer Verbindung zwischen der Eingabe/Ausgabe-Schnittstelle des Testgeräts und dem in dem Testgerät vorhandenen Modell, die die physikalische Signalübertragung über die Eingabe/Ausgabe-Schnittstelle gemäß dem mindestens einen Merkmal bei Erfüllung der mindestens einen Kommunikationsanforderung ermöglicht.

Das erfindungsgemäße Verfahren ermöglicht es, die in einem Basistestmodell vorhandenen, abstrakten Kommunikationsanforderungen zu nutzen, um die physikalische Kommunikation zwischen dem Testgerät und dem daran angeschlossenen Steuergerät bzw. dem daran angeschlossenen zu steuernden System zu ermöglichen. In anderen Worten, das erfindungsgemäße Verfahren ermöglicht eine Umsetzung der abstrakten Kommunikationsanforderungen des Basistestmodells in eine geeignete Konfiguration der Verbindung zwischen dem in dem Testgerät vorhandenen Modell und der Eingabe/Ausgabe-Schnittstelle des Testgeräts, so dass bei Zusammenwirkung des in dem Testgerät vorhandenen Modells und der Eingabe/Ausgabe-Schnittstelle durch die Konfiguration eine physikalische Signalübertragung durch die Eingabe/Ausgabe-Schnittstelle möglich wird, welche die abstrakten Kommunikationsanforderungen erfüllt. Durch das Extrahieren der Kommunikationsanforderungen aus dem Basistestmodell des Steuergeräts und das dementsprechende Festlegen von Merkmalen der physikalischen Signalübertragung des Testgeräts ist es möglich, die Mitwirkung eines menschlichen Experten bei der Konfiguration der genannten Verbindungen deutlich zu reduzieren bzw. ganz zu eliminieren. Die automatische Konfiguration der Verbindungen basiert auf der gezielten Auswertung eines bereits vorhandenen Basistestmodells. In der bisherigen Steuergerätentwicklung ist das schon vorhandene Basistestmodell außer Acht gelassen worden, sobald die Testphasen mit physikalischer Signalübertragung erreicht worden sind. Durch die Verwendung des Basistestmodells werden Synergien zwischen den unterschiedlichen Phasen der Steuergerätentwicklung geschaffen. Ein in einer ganz frühen Phase verwendetes Basistestmodell, wie z. B. eine Virtual Electronic Control Unit (VECU), wird hinsichtlich ganz bestimmter Parameter, nämlich hinsichtlich der Kommunikationsanforderungen, analysiert, wodurch das in einer späteren Entwicklungsphase zum Einsatz kommende Testgerät zumindest teilweise automatisch konfiguriert werden kann. Durch gezielte Extraktion von bestimmten Merkmalen eines Basistestmodells wird der Aufwand für die Konfiguration eines später verwendeten Testgeräts deutlich vermindert. Somit kann die Konfiguration des Testgeräts schneller erfolgen, was die Gesamtzeit der Steuergerätentwicklung vermindert. Außerdem ist bei der Konfiguration des Testgeräts weniger Expertenwissen nötig, was wiederum die Entwicklungszeit verkürzt und auch die Entwicklungskosten verringert.

Der Begriff Basistestmodell bezeichnet ein Testmodell des Steuergeräts, das in einer frühen Phase der Steuergerätentwicklung verwendet wird. Insbesondere bezeichnet der Begriff Basistestmodell ein Testmodell, das für den rein rechnergestützten Test der Funktionalität des Steuergeräts ausgelegt ist. Somit bezieht sich der Begriff also auf ein Testmodell des Steuergeräts, das in abstrakter Form vorliegt und im Regelfall vor der Durchführung einer Testphase mit einem physikalischen Testgerät vorhanden ist. Insofern liegen die Kommunikationsanforderungen, wie sie durch das Basistestmodell definiert sind, in abstrakter Form vor und werden auch als solche abstrakte Kommunikationsanforderungen aus dem Basistestmodell extrahiert. Wie oben schon erwähnt, ist ein Beispiel eines solchen Basistestmodells eine virtuelle elektronische Steuereinheit ("Virtual Electronic Control Unit", VECU).

Wie oben beschrieben, kommen bei der HIL-Simulation gegenständlich vorhandene Steuergeräte-Prototypen zum Einsatz, um die korrekte Funktion des Steuergeräts und insbesondere die korrekte Funktion der in dem Steuergerät vorhandenen Steuergeräte-Software zu testen. Mittels virtueller Absicherung und der zusätzlichen Verwendung virtueller Steuergeräte werden die Effizienz und die Testqualität der HIL-Simulation weiter gesteigert. Die virtuelle Absicherung beschreibt den Einsatz der PC-basierten Simulation für die Validierung, die Verifikation und den Test von Steuergeräte-Software. Sie bietet für die HIL-Simulation zum einen die Möglichkeit, Testszenarien vorab auf einer PC-basierten Simulationsplattform zu erstellen und zu validieren sowie das Simulationsmodell zu konfigurieren. Zum anderen können unter Verwendung virtueller Steuergeräte erste Testszenarien durchlaufen werden. Ohne Verbindung zu einem realen, physikalischen System lassen sich so auf dem PC Open-Loop- und Closed-Loop-Tests von Steuergeräte-Software und Streckenmodell durchführen, um Fehler aufzuspüren und dadurch die Qualität der Steuergeräte-Software bereits vor der eigentlichen HIL-Simulation zu steigern. Durch diese Vorverlagerung von Testerstellung und Testvorbereitung wird die Zeit am HIL-Simulator effizienter genutzt.

Die Simulationsplattform VEOS ® erlaubt bereits in frühen Entwicklungsphasen eine PCbasierte Simulation einzelner Software-Komponenten von Steuergeräten sowie von Steuergeräte-Netzwerken. Anwender können in ihrer gewohnten Arbeitsumgebung weiterarbeiten und bereits vorhandene Daten, Modelle, Layouts und Konfigurationen wiederverwenden. Dieselben V-ECUs, Modelle, Layouts und Simulationsszenarien, die für VEOS ® erstellt und verwendet werden, lassen sich in der HIL-Simulation wiederverwenden, so dass sich der Vorbereitungsaufwand für HIL-Tests reduziert.

Falls in einem HIL-Szenario ein notwendiger Teil des Steuergeräte-Netzwerks nicht als reale Steuergeräte-Hardware vorhanden ist, kann dieser in Form einer V-ECU verfügbar gemacht und für die HIL-Simulation genutzt werden. Hierfür kann die Steuergeräte-Software in Form von AUTOSAR Software-Komponenten vorliegen. Die V-ECU kann direkt in die HIL-Simulation integriert werden, so dass eine gesonderte, aufwendige Nachmodellierung des Software-Verhaltens in einem Verhaltensmodell entfällt. Durch diese Wiederverwendung von bereits vorhandenem Steuergeräte-Code spart der Anwender Entwicklungs- und Validierungsaufwand.

V-ECUs können die gleichen Funktionen und Software-Komponenten wie die finalen Steuergeräte bieten. Je nach Anforderung an die Detailtiefe der Tests können sie in verschiedenen Ausprägungen vorliegen, z.B. können sie mit einzelnen Steuergerätefunktionen versehen sein oder mit mehreren oder allen Applikationssoftware-Komponenten versehen sein oder mit der komplett integrierten und konfigurierten Applikationssoftware, der Laufzeitumgebung, dem Betriebssystem und hardwareunabhängiger Basis-Software versehen sein. Je nach Ausprägung kann der Umfang der zu extrahierenden Kommunikationsanforderung variieren. Auch die Art und Weise, wie die Kommunikationsanforderung extrahiert wird, kann von der Ausprägung der V-ECU abhängen. In der ersten Ausprägung kann die Steuergerätefunktion z.B. als Simulink-Modell oder C-Code vorliegen, aus dem dann die Kommunikationsanforderung (Datentyp, Datenbreite, ...) extrahiert wird. In detaillierteren Ausprägungen können weitere beschreibende Strukturen zur V-ECU hinzukommen, wie z. B XML Dateien, aus denen dann auch weitere oder andere Kommunikationsanforderungen (z.B. Übertragungshäufigkeit, Latenzzeit, Genauigkeit, Einheit, ...) extrahiert werden können.

Viele Aspekte des Steuergeräte-Echtzeitverhaltens lassen sich mit V-ECUs vergleichsweise einfach und gleichzeitig realistisch simulieren, indem Software-Anteile aus der Steuergeräte-Entwicklung wiederverwendet werden. So ist es möglich, bereits frühzeitig, vor der Verfügbarkeit des fertigen Steuergerätes, realitätsnahe Ergebnisse zu erzielen und die Funktionsqualität zu erhöhen. Die Software-seitige Konfigurierbarkeit der HIL-Systeme und die Möglichkeit der PC-basierten Vorabsimulation helfen zudem dabei, Inbetriebnahme- und Rüstzeiten am HIL-Simulator zu verkürzen. Die neuen Technologien der virtuellen Absicherung und die Verwendung von V-ECUs finden so Einzug in bestehende Absicherungs- und Testprozesse für Steuergeräte-Software.

Das Konfigurieren der mindestens einen Verbindung zwischen der Eingabe/Ausgabe-Schnittstelle des Testgeräts und dem in dem Testgerät vorhandenen Modell stellt das Erstellen und Parametrisieren einer geeigneten Verbindung zwischen der Hardware-mäßig implementierten Eingabe/Ausgabe-Schnittstelle des Testgeräts und dem in dem Testgerät vorhandenen Software-Modell dar. Dementsprechend kann bei der Verbindung auch von einer Treiber-mäßigen Verbindung gesprochen werden, welche die Kommunikation zwischen dem in dem Testgerät vorhandenen Modell, das als Software-Modul bzw. als Ansammlung von Software-Modulen vorliegt, und der mit physikalischen Signalen operierenden Eingabe/Ausgabe-Schnittstelle ermöglicht.

Der Ausdruck, dass die Eingabe/Ausgabe-Schnittstelle zum Anschluss einer gerätemäßigen Implementierung des Steuergeräts oder zum Anschluss eines zu steuernden technischen Systems ausgebildet ist und dass das mit der Eingabe/Ausgabe-Schnittstelle zu verbindende Modell ein Testmodell des zu steuernden technischen Systems oder ein Testmodell des Steuergeräts ist, impliziert zwei verschiedene Szenarien. Zum einen kann die Eingabe/Ausgabe-Schnittstelle zum Anschluss der gerätemäßigen Implementierung des Steuergeräts ausgebildet sein, wobei dann das mit der Eingabe/Ausgabe-Schnittstelle zu verbindende Modell ein Testmodell des zu steuernden technischen Systems ist. In diesem Fall ist der Schritt des Konfigurierens von mindestens einer Verbindung ein Konfigurieren von mindestens einer Verbindung zwischen der Eingabe/Ausgabe-Schnittstelle des Testgeräts und des Testmodells des zu steuernden technischen Systems. Die physikalische Signalübertragung findet dann zwischen der Eingabe/Ausgabe-Schnittstelle des Testgeräts und der gerätemäßigen Implementierung des Steuergeräts statt. Zum anderen kann die Eingabe/Ausgabe-Schnittstelle zum Anschluss eines zu steuernden technischen Systems ausgebildet sein, wobei dann das mit der Eingabe/Ausgabe-Schnittstelle zu verbindende Modell ein Testmodell des Steuergeräts ist. In diesem Fall ist der Schritt des Konfigurierens von mindestens einer Verbindung ein Konfigurieren von mindestens einer Verbindung zwischen der Eingabe/Ausgabe-Schnittstelle des Testgeräts und des Testmodells des Steuergeräts. Die physikalische Signalübertragung findet dann zwischen der Eingabe/Ausgabe-Schnittstelle des Testgeräts und dem zu steuernden technischen System statt. Der Schritt des Konfigurierens von mindestens einer Verbindung kann das Konfigurieren der mindestens einen Verbindung zusätzlich davon abhängig machen, ob die gerätemäßige Implementierung des Steuergeräts von extern an die Eingabe/Ausgabe-Schnittstelle anzuschließen ist oder ob das Testmodell des Steuergeräts in dem Testgerät vorhanden ist, und kann auf der Basis davon die Übertragungsrichtung bzw. die Übertragungsrichtungen der mindestens einen Verbindung festlegen. Die Ausdrücke der angeschlossenen gerätemäßigen Implementierung des Steuergeräts bzw. des angeschlossenen technischen Systems beinhalten auch den Fall, dass das an das Testgerät anzuschließende Gerät wiederum ein Simulationsgerät ist, das eine Hardware-Schnittstelle zum Anschluss an die Eingabe/Ausgabe-Schnittstelle des Testgeräts und ein Software-Modell des Steuergeräts bzw. des angeschlossenen technischen Systems aufweist. Der Ausdruck zum Anschluss einer gerätemäßigen Implementierung des Steuergeräts beinhaltet den Fall des Anschlusses eines Simulationsgeräts, aufweisend eine gegenständliche Schnittstelle und ein mit der gegenständlichen Schnittstelle verbundene Software-Implementierung der Steuergerät-Funktionalität. Analog beinhaltet der Ausdruck zum Anschluss eines zu steuernden technischen Systems den Fall des Anschlusses eines Simulationsgeräts, aufweisend eine gegenständliche Schnittstelle und ein mit der gegenständlichen Schnittstelle verbundene, Modell-mäßige Implementierung des zu steuernden technischen Systems.

Der Begriff Testgerät beschreibt eine physisch vorhandene Einheit, d.h. ein gegenständliches Testgerät, wobei die Einheit eine physische Eingabe/Ausgabe-Schnittstelle, wie z.B. eine Anschluss-Leiste zum Verbinden verschiedener Kabel, hat. Dabei soll der Begriff Testgerät nicht implizieren, dass diese Einheit aus genau einem Element besteht. Das Testgerät kann aus mehreren Elementen, wie z.B. einem oder mehreren Anschluss-Modul(en) und einem oder mehreren Computer(n), der/die die Rechenkapazität zur Verfügung stellt/stellen, bestehen.

Der Begriff Eingabe/Ausgabe-Schnittstelle bezeichnet die Gesamtheit der Teile der physischen Anschlussstruktur des Testgeräts, an die gerätemäßige Implementierungen von Steuergeräten und/oder zu steuernde technische Systeme zu Testzwecken angeschlossen werden können.

Das Verwenden des Basistestmodells für die Konfiguration des Testgeräts kann auch Effizienzsteigerungen für den gesamten Entwicklungsprozess des Steuergeräts zur Folge haben. Es ist möglich, das beschriebene Verfahren nicht nur zum Verbinden der Eingabe/Ausgabe-Schnittstelle des Testgeräts mit dem in dem Testgerät vorhandenen Modell zu verwenden, sondern ein analoges bzw. das gleiche Verfahren auch für die Erstellung des letztendlichen Steuergeräts zu verwenden. D.h. auf Basis der Kommunikationsanforderungen des Basistestmodells kann eine Eingabe/Ausgabe-Schnittstelle des Steuergeräts mit der in dem Steuergerät vorhandenen Software, welche die Steuer- bzw. Regelalgorithmen des Steuergeräts enthält, verbunden werden. Es ist dabei möglich, dass das Verfahren nur einmal durchgeführt wird und dass die Ergebnisse sowohl für die Konfiguration des Steuergeräts als auch für die Konfiguration des Testgeräts verwendet werden. Dadurch ist bei Betrachtung des gesamten Prozesses der Steuergerätentwicklung eine Effizienzsteigerung zu verzeichnen. Außerdem kann dadurch für den Fall einer HIL-Simulation die Kompatibilität zwischen dem Testgerät und dem angeschlossenen Steuergerät verbessert werden, weil beide Geräte bezüglich der Konfiguration ihrer Eingabe/Ausgabe-Schnittstelle auf dem gleichen Basistestmodell und auf dem gleichen Verfahren zum Verbinden der jeweiligen Eingabe/Ausgabe-Schnittstelle mit dem Rest des jeweiligen Geräts beruhen.

Gemäß einer weiteren Ausführungsform weist der Schritt des Festlegens von mindestens einem Merkmal einer physikalischen Signalübertragung die folgenden Schritte auf: Ausgeben der mindestens einen Kommunikationsanforderung an eine externe Instanz; und Empfangen einer Angabe von der externen Instanz, wobei die Angabe das mindestens eine, mit der mindestens einen Kommunikationsanforderung assoziierte Merkmal definiert. In anderen Worten, das Verfahren zum Verbinden der Eingabe/Ausgabe-Schnittstelle wendet sich nach dem Extrahieren der mindestens einen Kommunikationsanforderung aus dem Basistestmodell des Steuergeräts an eine externe Instanz, um mit Hilfe der von der externen Instanz empfangenen mindestens einen Angabe das mindestens eine Merkmal der physikalischen Signalübertragung festzulegen. Auf diese Weise bereitet das Verfahren die aus dem Basistestmodell extrahierte Information derart für eine externe Instanz auf, dass diese externe Instanz durch Vornehmen einer Angabe direkt Einfluss auf die Festlegung des mindestens einen Merkmals der physikalischen Signalübertragung nehmen kann. Somit ermöglicht das Verfahren durch zielgerichtetes Extrahieren und Ausgeben der mindestens einen Kommunikationsanforderung ein Festlegen des mindestens einen Merkmals der physikalischen Signalübertragung mit geringem Aufwand auf Seiten der externen Instanz. Der Begriff des mit der mindestens einen Kommunikationsanforderung assoziierten Merkmals bezieht sich auf das Merkmal der physikalischen Signalübertragung, die für die Kommunikationsanforderung geeignet ist, wobei das Merkmal auf der Basis der mindestens einen Kommunikationsanforderung festgelegt wird.

Gemäß einer weiteren Ausführungsform ist die externe Instanz ein Benutzer oder ein externes Kommunikationsprogramm. In anderen Worten, die genannte Angabe von der externen Instanz kann das Resultat einer menschlichen Eingabe sein. Der Benutzer des Verfahrens, d.h. im Regelfall der Test-Ingenieur, welcher das Konfigurieren der Verbindungen zwischen der Eingabe/Ausgabe-Schnittstelle des Testgeräts und dem in dem Testgerät vorhandenen Modell begleitet bzw. überwacht, kann so auf das Festlegen des mindestens einen Merkmals der physikalischen Signalübertragung einwirken und so den Prozess der Test-Konfiguration zu einem relativ frühen Stadium des Verfahrens steuern. Diese Aufgabe kann statt von einem menschlichen Benutzer auch von einem externen Konfigurationsprogramm wahrgenommen werden. Dieses Programm kann Zuordnungen enthalten, die in algorithmischer Weise den ausgegebenen Kommunikationsanforderungen Angaben zuweisen, die dann wiederum die Merkmale der physikalischen Signalübertragung definieren. Auf diese Weise können die Schritte des Extrahierens der mindestens einen Kommunikationsanforderung und des Festlegens des mindestens einen Merkmals der physikalischen Signalübertragung vollautomatisch, d. h. ohne menschliches Zutun, durchgeführt werden.

Gemäß einer weiteren Ausführungsform weist der Schritt des Festlegens von mindestens einem Merkmal einer physikalischen Signalübertragung die folgenden Schritte auf: Zugreifen auf einen Datensatz, der Korrelationen zwischen Kommunikationsanforderungen und Merkmalen physikalischer Signalübertragungen enthält; und Auswählen des mindestens einen Merkmals der physikalischen Signalübertragung auf Basis der Korrelationen. In diesem Fall wird für das Festlegen des mindestens einen Merkmals der physikalischen Signalübertragung auf einen vorhandenen Datensatz zugegriffen, um das mindestens eine Merkmal der physikalischen Signalübertragung auf geeignete Weise auf Basis der extrahierten mindestens einen Kommunikationsanforderung festzulegen. Der dafür verwendete Datensatz, der die genannten Korrelationen enthält, kann Teil des Basistestmodells sein oder kann als standardmäßig verwendeter Datensatz, z. B. als Teil einer Software-Bibliothek, vorliegen, so dass das Verfahren direkten Zugriff auf diesen Datensatz hat. In diesem Fall ist die Kommunikation mit einer externen Instanz nicht unbedingt notwendig. Es kann allerdings sein, dass das Zugreifen auf den Datensatz, der Korrelationen zwischen Kommunikationsanforderungen und Merkmalen physikalischer Signalübertragung enthält, und die oben beschriebene Kommunikation mit der externen Instanz in Kombination vorliegen. Zum Beispiel ist es möglich, dass zwei oder mehr Möglichkeiten für das mindestens eine Merkmal der physikalischen Signalübertragung auf Basis der Korrelationen ausgewählt werden und dass diese zwei oder mehr Möglichkeiten an die externe Instanz ausgegeben werden, wobei das Empfangen der Angabe von der externen Instanz in dem Empfangen einer Auswahl aus den zwei oder mehr Möglichkeiten besteht. Auf diese Weise kann die Interaktion für die externe Instanz, wie z.B. für den Test-Ingenieur, noch weiter vereinfacht werden.

Gemäß einer weiteren Ausführungsform erfolgt der Schritt des Festlegens von mindestens einem Merkmal einer physikalischen Übertragung nur unter Verwendung der mindestens einen Kommunikationsanforderung bzw. unter Verwendung der mindestens einen Kommunikationsanforderung in Verbindung mit weiteren, in dem Basistestmodell vorhandenen Daten. In anderen Worten, die in dem Basistestmodell vorhandene Information wird algorithmisch so verarbeitet, dass das mindestens eine Merkmal der physikalischen Signalübertragung durch das Verfahren zum Verbinden der Eingabe/Ausgabe-Schnittstelle festgelegt wird, ohne für diese Festlegung mit einer externen Instanz kommunizieren zu müssen.

Gemäß einer weiteren Ausführungsform weist der Schritt des Konfigurierens der mindestens einen Verbindung zwischen der Eingabe/Ausgabe-Schnittstelle des Testgeräts und dem in dem Testgerät vorhandenen Modell die folgenden Schritte auf: Ausgeben von mehreren möglichen Verbindungsvorschlägen zwischen der Eingabe/Ausgabe-Schnittstelle des Testgeräts und dem in dem Testgerät vorhandenen Modell zur Auswahl an einen Benutzer; und Empfangen der Auswahl der mindestens einen Verbindung von dem Benutzer. Eine Verbindung zwischen der Eingabe/Ausgabe-Schnittstelle des Testgeräts und dem in dem Testgerät vorhandenen Modell zeichnet sich dadurch aus, dass die Kommunikation über diese Verbindung sowohl der extrahierten mindestens einen Kommunikationsanforderung als auch dem festgelegten mindestens einen Merkmal der physikalischen Signalübertragung Rechnung trägt. In anderen Worten, diese genannte Verbindung ermöglicht den Übergang zwischen der Hardware-mäßig vorhandenen Eingabe/Ausgabe-Schnittstelle und dem Software-mäßig vorhandenen, in dem Testgerät vorhandenen Modell auf eine solche Weise, dass die extrahierte, abstrakte Kommunikationsanforderung sowie die festgelegte, konkrete physikalische Signalübertragung gleichzeitig ermöglicht werden. Im Regelfall gibt es für die Kombination von mindestens einer Kommunikationsanforderung und mindestens einem Merkmal der physikalischen Signalübertragung mehrere mögliche Verbindungen. Dabei ist es möglich, dass die mindestens eine Verbindung durch das Verfahren zum Verbinden der Eingabe/Ausgabe-Schnittstelle ohne Einbeziehung eines Benutzers konfiguriert wird. Es ist aber auch möglich, wie durch die zusätzlichen Schritte oben beschrieben, dass das Verfahren mehrere mögliche Verbindungsvorschläge zur Auswahl an den Benutzer ausgibt und eine entsprechende Auswahl durch den Benutzer empfängt. Auf diese Weise ist es möglich, dass der Benutzer zu einem relativ späten Stadium des Verfahrens auf den Konfigurationsprozess einwirkt. Auf diese Weise kann er mit seinem Expertenwissen dafür sorgen, dass die Verbindung bzw. die Gesamtheit aller Verbindungen derart ist, dass der Test in besonders effektiver Weise, z.B. mit besonders hoher Geschwindigkeit und/oder mit besonders hoher Genauigkeit, abläuft.

Gemäß einer alternativen Ausführungsform weist der Schritt des Konfigurierens der mindestens einen Verbindung zwischen der Eingabe/Ausgabe-Schnittstelle des Testgeräts und dem in dem Testgerät vorhandenen Modell die folgenden Schritte auf: Ausgeben von genau einem möglichen Verbindungsvorschlag zwischen der Eingabe/Ausgabe-Schnittstelle des Testgeräts und dem in dem Testgerät vorhandenen Modell zur Auswahl an einen Benutzer; und Empfangen einer Bestätigung oder einer Ablehnung von dem Benutzer. Auf diese Weise wird von dem Benutzer lediglich eine ja/nein-Entscheidung verlangt, wodurch der Konfigurationsprozess für den Benutzer weiter vereinfacht wird. Diese Schritte können iterativ ausgeführt werden, wobei dem Benutzer nach Ablehnung des einen möglichen Verbindungsvorschlages genau ein weiterer möglicher Verbindungsvorschlag zur Bestätigung oder Ablehnung gemacht wird.

Gemäß einer weiteren Ausführungsform weist die Eingabe/Ausgabe-Schnittstelle des Testgeräts eine Mehrzahl von Anschlüssen auf, und das Testgerät weist eine Mehrzahl von Eingabe/Ausgabe-Funktionen auf, die mit dem in dem Testgerät vorhandenen Modell und mit der Eingabe/Ausgabe-Schnittstelle verbunden sind. Dabei weist der Schritt des Konfigurierens der mindestens einen Verbindung zwischen der Eingabe/Ausgabe-Schnittstelle des Testgeräts und dem in dem Testgerät vorhandenen Modell die folgenden Schritte auf: Auswählen von mindestens einem Anschluss der Mehrzahl von Anschlüssen; und Parametrisieren von mindestens einer Eingabe/Ausgabe-Funktion der Mehrzahl von Eingabe/Ausgabe-Funktionen, wobei die mindestens eine Eingabe/Ausgabe-Funktion den mindestens einen Anschluss steuert und wobei das Parametrisieren die mindestens eine Eingabe/Ausgabe-Funktion so einrichtet, dass sie während des Testens die physikalische Signalübertragung über die Eingabe/Ausgabe-Schnittstelle gemäß dem mindestens einen Merkmal bei Erfüllung der mindestens einen Kommunikationsanforderung ausführt. Eingabe/Ausgabe-Funktionen sind eine Möglichkeit für das Bindeglied zwischen dem Modell auf der einen Seite und der gegenständlichen Eingabe/Ausgabe-Schnittstelle auf der anderen Seite. Sie stellen eine Brücke zwischen den auf der Eingabe/Ausgabe-Schnittstelle vorhandenen physikalischen Signalen und dem in Software vorhandenen Modell dar. Um dabei sowohl den Merkmalen der physikalischen Signalübertragung als auch den abstrakten Kommunikationsanforderungen Rechnung zu tragen, werden die Eingabe/Ausgabe-Funktionen parametrisiert, d.h. an die Kommunikationsanforderung(en) und das Merkmal/die Merkmale der physikalischen Signalübertragung angepasst. Nach dieser Anpassung sind die Eingabe/Ausgabe-Funktionen in der Lage, den mindestens einen Anschluss zu steuern, d.h. ausgehende Signale auf dem Anschluss zu veranlassen und/oder eingehende Signale auf dem Anschluss zu empfangen. Dabei setzen die Eingabe/Ausgabe-Funktionen physikalische Signale in von Software zu verarbeitende Logik-Signale um und umgekehrt.

Gemäß einer weiteren Ausführungsform ist die mindestens eine Kommunikationsanforderung ein Parameter oder ein Parameter-Set aus der Gruppe, bestehend aus Datentyp, Datenbreite, physikalischer Einheit, Anschluss-Typ, Übertragungshäufigkeit, Latenzzeit, Wertebereich und Wertegenauigkeit. Unter dem Begriff Anschluss-Typ wird hierin die Unterscheidung zwischen einem Eingabe-Anschluss und einem Ausgabe-Anschluss verstanden. Außerdem kann der Anschluss-Typ noch die Unterscheidung zwischen Signalen, die kontinuierlich übermittelt werden, und Signalen, die bestimmte Ereignisse anzeigen, wie z.B. Impuls-Signalen, Konfigurationssignalen, etc., enthalten. Unter Datentyp wird die Datenart verstanden, mit der das Basistestmodell für eine bestimmte Kommunikationsanforderung operiert, wie z. B. integer, float, etc. Der Datentyp kann ein Indikator für Wertebereich und die Wertegenauigkeit sein, allerdings können diese Parameter auch recht stark von dem bzw. der mit dem Datentyp möglichen Wertebereich bzw. Wertegenauigkeit abweichen. Unter Datenbreite wird verstanden, ob es sich um einen Skalar oder einen Vektor handelt, also ob es sich um einen Wert oder um eine Mehrzahl von Werten handelt. Wenn es sich um einen Vektor handelt, kann die Datenbreite auch die Information über die Vektorgröße umfassen.

Gemäß einer weiteren Ausführungsform ist das mindestens eine Merkmal der physikalischen Signalübertragung aus der Gruppe, bestehend aus Signalübertragung per Spannung, Signalübertragung per Strom, physikalischer Spannungsbereich, physikalischer Strombereich, Digitalübertragung, Analogübertragung, Übertragung per Pulsweitenmodulation, Übertragung per Pulsfrequenzmodulation, Übertragung per Datenbus, Datenübertragungsrate. Diese Merkmale erlauben eine Auswahl der physikalischen Signalübertragung bzgl. der Übertragungsart (analog bzw. digital) bzgl. der Signal-führenden physikalischen Größe (Strom bzw. Spannung), bzgl. der informationstragenden Größe (Absolutwert bzw. Pulsbreite bzw. Pulsfrequenz) und bzgl. der zeitlichen Charakteristik der Übertragung bzw. der Bündelung mit anderen Übertragungen (z. B. über einen Datenbus).

Das Festlegen des mindestens einen Merkmals der physikalischen Signalübertragung auf der Basis der mindestens einen Kommunikationsanforderung kann auf einer Vielzahl von Überlegungen beruhen. Beispielhaft werden im Folgenden einige solcher Überlegungen genannt. Wenn ein Wert mit geringer Wertegenauigkeit übertragen werden soll, bietet sich eine Übertragung per Spannung an. Wenn mit der Übertragung eines Wertes auch eine entsprechende elektrische Leistung übertragen werden soll, bietet sich eine Übertragung per Pulsweitenmodulation an. Wenn ein Wert mit großer Wertegenauigkeit übertragen werden soll, bietet sich eine Übertragung per Datenbus an. Wenn ein Signal über eine große Distanz, möglicherweise in einer Umgebung mit vielen Störungen, übertragen werden soll, bietet sich ebenfalls eine Übertragung per Datenbus an. Wenn insgesamt nur wenig Information übertragen werden soll, bietet sich die Übertragung per Datenbus aufgrund der hohen Komplexität und Kosten nicht unbedingt an. Ebenfalls bietet sich eine Datenübertragung per Datenbus nicht an, wenn ein Wert mit sehr geringer oder fest definierter Latenzzeit übertragen werden soll. Es ist ersichtlich, dass es viele weitere solche Überlegungen gibt, die für bestimmte Kommunikationsanforderungen geeignete bzw. weniger geeignete Merkmale der physikalischen Signalübertragung bereitstellen. Wie oben detailliert ausgeführt, können solche Überlegungen mit Hilfe von einem Datensatz mit Korrelationen zwischen Kommunikationsanforderungen und Merkmalen physikalischer Signalübertragungen abgebildet sein, auf die maschinell zugegriffen werden kann. Es ist auch möglich, dass solche Überlegungen in externe Konfigurationsprogramme eingebettet sind, und durch Abfrage dieser die Merkmale der physikalischen Signalübertragung festgelegt werden. Außerdem ist es möglich, wie oben erwähnt, dass Kommunikationsanforderungen an den Benutzer ausgegeben werden, um dessen Input bzgl. des Festlegens der Merkmale der physikalischen Signalübertragung abzufragen. Wie auch oben im Detail erläutert, können diese Ansätze miteinander korreliert werden, wobei das Festlegen teilweise Maschinen-basiert und teilweise Benutzer-unterstützt abläuft.

Gemäß einer weiteren Ausführungsform umfasst der Schritt des Extrahierens von mindestens einer Kommunikationsanforderung des zu testenden Steuergeräts aus dem Basistestmodell das Extrahieren aller Kommunikationsanforderungen des zu testenden Steuergeräts, und der Schritt des Festlegens von mindestens einem Merkmal einer physikalischen Signalübertragung umfasst das Festlegen einer Mehrzahl von Merkmalen der physikalischen Signalübertragung, wobei die Mehrzahl von Merkmalen alle Kommunikationsanforderungen abdeckt. Auf diese Weise konfiguriert das Verfahren in dem Schritt des Konfigurierens von mindestens einer Verbindung alle Verbindungen zwischen der Eingabe/Ausgabe-Schnittstelle des Testgeräts und dem in dem Testgerät vorhandenen Modell, die für eine vollumfängliche Kommunikation zwischen der Eingabe/Ausgabe-Schnittstelle und dem in dem Testgerät vorhandenen Modell eines technischen Systems erforderlich sind, um die Funktionalität des Steuergeräts zu testen. Bei dieser Ausführungsform können die Schritte des Extrahierens der Kommunikationsanforderungen und des Festlegens der Merkmale der physikalischen Signalübertragung iterativ ausgeführt werden, wobei sich jeder dieser Schritte bei jeder Ausführung auf eine Untermenge der Gesamtheit aller Kommunikationsanforderungen bezieht. Es ist aber auch möglich, dass das Verfahren in integraler Weise alle Kommunikationsanforderungen gleichzeitig zu geeigneten Merkmalen der physikalischen Signalübertragung verarbeitet.

Gemäß einer weiteren Ausführungsform weist der Schritt des Konfigurierens der mindestens einen Verbindung zwischen der Eingabe/Ausgabe-Schnittstelle des Testgeräts und dem in dem Testgerät vorhandenen Modell das Konfigurieren einer Mehrzahl von Verbindungen zwischen der Eingabe/Ausgabe-Schnittstelle des Testgeräts auf. Insbesondere kann der Schritt des Konfigurierens das Konfigurieren einer solchen Mehrzahl von Verbindungen zwischen der Eingabe/Ausgabe-Schnittstelle des Testgeräts aufweisen, das alle Kommunikationsanforderungen des Basistestmodells über diese Mehrzahl von Verbindungen bedient werden können. Weiterhin ist es möglich, dass der Schritt des Konfigurierens der mindestens einen Verbindung zwischen der Eingabe/Ausgabe-Schnittstelle in diesem Fall ferner den folgenden Schritt aufweist: Zusammenfassen von mindestens zwei Verbindungen, die sich einen bestimmten Anschluss der Eingabe/Ausgabe-Schnittstelle teilen, durch Definieren einer Zugriffsordnung auf den bestimmten Anschluss. Das Definieren der Zugriffsordnung auf den bestimmten Anschluss kann das Definieren verschiedener Übertragungskanäle auf den bestimmten Anschluss durch einen Multiplex-Zugriff, wie z.B. einen zeitlichen Multiplex oder einen Frequenz-Multiplex, aufweisen. Ein Beispiel eines solchen Multiplex-Zugriffs auf einen bestimmten Anschluss ist eine Bus-Kommunikation auf dem bestimmten Anschluss. Dabei teilen sich mehrere Verbindungen die zur Verfügung stehende Hardware-Ressource nach einem festgelegten Protokoll. Auf diese Weise kann die Anzahl der benötigten Hardware-Ressourcen für die physikalische Signalübertragung reduziert bzw. klein gehalten werden.

Gemäß einer weiteren Ausführungsform ist das Testgerät ein Hardware-in-the-Loop-Simulationsgerät, und ist die Eingabe/Ausgabe-Schnittstelle zum Anschluss der gerätemäßigen Implementierung des Steuergeräts ausgebildet, und ist das mit der Eingabe/Ausgabe-Schnittstelle zu verbindende Modell das Testmodell des zu steuernden technischen Systems.

Gemäß einer alternativen Ausführungsform ist das Testgerät ein Rapid-Control-Prototyping-Testgerät, und ist die Eingabe/Ausgabe-Schnittstelle zum Anschluss des zu steuernden technischen Systems ausgebildet, und ist das mit der Eingabe/Ausgabe-Schnittstelle zu verbindende Modell das Testmodell des Steuergeräts. In diesem Fall kann das Testmodell des Steuergeräts des Rapid-Control-Prototyping-Testgeräts dem bereits vorhandenen Basistestmodell entsprechen.

Gemäß einer weiteren Ausführungsform weist der Schritt des Konfigurierens von mindestens einer Verbindung zwischen der Eingabe/Ausgabe-Schnittstelle des Testgeräts und dem in dem Testgerät vorhandenen Modell den folgenden Schritt auf: Konfigurieren von mindestens einer fehlerbehafteten Verbindung zwischen der Eingabe/Ausgabe-Schnittstelle des Testgeräts und dem in dem Testgerät vorhandenen Modell, wobei die mindestens eine fehlerbehaftete Verbindung eingerichtet ist, Übertragungsfehler und/oder Störeinflüsse zu simulieren. Auf diese Weise können während der späteren Simulation Fälle getestet werden, in denen die Kommunikation zwischen dem Steuergerät und dem zu steuernden technischen System nicht einwandfrei funktioniert, wie z. B. im Fall eines Kabelbruchs, eines Kurzschlusses, elektromagnetischer Störfelder oder anderer, sich auf die Übertragung auswirkender Umwelteinflüsse. Dabei kann das Konfigurieren der mindestens einen fehlerhaften Verbindung die Auswahl eines vorkonfigurierten Anschlusses der Eingabe/Ausgabe-Schnittstelle aufweisen, welcher ausgebildet ist, die Übertragungsfehler und/oder Störeinflüsse zu simulieren. Alternativ kann die Verbindung zwischen der Eingabe/Ausgabe-Schnittstelle, wie z.B. die verwendete Eingabe/Ausgabe-Funktion, so eingerichtet werden, dass die Übertragungsfehler und/oder Störeinflüsse simuliert werden.

Beispielhafte Ausführungsformen der Erfindung umfassen weiterhin ein Computerprogrammprodukt sowie Computerprogramm zur Ausführung eines Verfahrens zum Verbinden einer Eingabe/Ausgabe-Schnittstelle eines für die Steuergeräteentwicklung eingerichteten Testgeräts, wobei das Computerprogrammprodukt so ausgebildet ist, dass bei Ausführung des Computerprogramms ein Verfahren ausgeführt wird, wie es in einer der vorstehend beschriebenen Ausführungsformen definiert ist.

Beispielhafte Ausführungsformen der Erfindung umfassen weiterhin ein Testgerät, das eine Eingabe/Ausgabe-Schnittstelle zum Anschluss einer gerätemäßigen Implementierung eines Steuergeräts oder zum Anschluss eines zu steuernden technischen Systems und ein Testmodell des zu steuernden technischen Systems oder ein Testmodell des Steuergeräts aufweist. Dabei ist das Testgerät eingerichtet, ein Verfahren gemäß einer der vorstehend beschriebenen Ausführungsformen auszuführen. Zu diesem Zweck kann das Testgerät einen Prozessor und einen Speicher haben, wobei in dem Speicher ein Computerprogramm abgelegt ist, das bei Ausführung durch den Prozessor zu einem Verfahren gemäß einer der vorstehend beschriebenen Ausführungsformen führt. Der Prozessor und der Speicher können sowohl für das Vorhalten und Ausführen des erfindungsgemäßen Verfahrens als auch für das Vorhalten und Ausführen des später ausgeführten Testprogramms vorgesehen sein. Es ist aber auch möglich, dass das Testgerät mehrere Module aufweist. Bspw. kann ein Testmodul, welches die Eingabe/Ausgabe-Schnittstelle und das Modell des technischen Systems aufweist, für die Durchführung der Simulation einen Prozessor und einen Speicher haben, während ein Konfigurationsmodul separat ausgeführt sein kann, welches einen Speicher und einen Prozessor für die Ausführung des erfindungsgemäßen Verfahrens aufweist. Dieses Konfigurationsmodul kann ein separater Rechner sein, der mit dem Testmodul verbunden ist.

Weitere beispielhafte Ausführungsformen werden im Folgenden mit Bezug auf die beiliegenden Figuren beschrieben:
Figur 1 zeigt die Kombination eines beispielhaften Basistestmodells und eines Modells eines zu steuernden technischen Systems;
Figur 2 zeigt eine beispielhafte Kombination eines Testgeräts gemäß einer beispielhaften Ausführungsform der Erfindung und einer gerätemäßigen Implementierung des Steuergeräts;
Figur 3 zeigt ein beispielhaftes Testgerät gemäß einer Ausführungsform der Erfindung; und
Figur 4 zeigt ein beispielhaftes Testgerät gemäß einer weiteren Ausführungsform der Erfindung, in Kombination mit einem externen Konfigurations-Rechner.

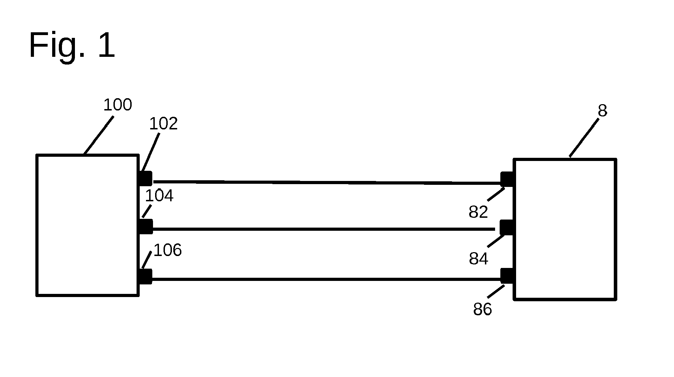

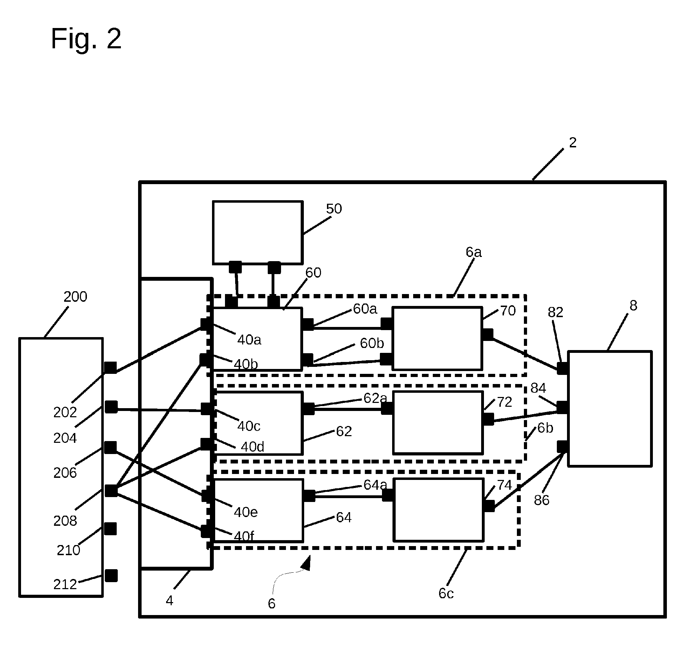

Anhand der Figuren 1 und 2 wird im Folgenden beispielhaft beschrieben, wie gemäß einer Ausführungsform des erfindungsgemäßen Verfahrens auf der Grundlage eines Basistestmodells eines Steuergeräts ein Testgerät eingerichtet wird, das eine gerätemäßige Implementierung des Steuergeräts testen kann. Zu diesem Zweck werden zuerst die gezeigten Blockschaltbilder beschrieben, bevor die beispielhafte Ausführungsform des erfindungsgemäßen Verfahrens beschrieben wird.

Figur 1 zeigt ein Basistestmodell 100 einer Lüftersteuerung. Die Lüftersteuerung ist ein Beispiel eines Steuergeräts im Sinne der vorliegenden Erfindung. Das Basistestmodell 100 liegt in Software vor und ist für einen rein rechnergestützten Basistest der Lüftersteuerung vorgesehen und geeignet. Das Basistestmodell 100 kann auch als virtuelles Steuergerät bzw. als virtuelle Lüftersteuerung bezeichnet werden.

Das Basistestmodell 100 hat eine erste Kommunikationsschnittstelle 102, eine zweite Kommunikationsschnittstelle 104 und eine dritte Kommunikationsschnittstelle 106. Über die erste Kommunikationsschnittstelle 102 kommuniziert das Basistestmodell 100 einen Leistungswert, der im Basistest die von dem Lüfter abgegebene Leistung kodiert. Über die zweite Kommunikationsschnittstelle 104 empfängt das Basistestmodell 100 einen Temperaturwert, der im Basistest die von einem Temperatursensor empfangene Temperatur kodiert. Über die dritte Kommunikationsschnittstelle 106 wird in dem Basistest eine Indikation für die Stellung des Ein/Aus-Schalters des Lüfters empfangen.

Figur 1 zeigt weiterhin das Testmodell 8 des von der Lüftersteuerung zu steuernden technischen Systems. In der beispielhaften Ausführungsform von Figur 1 ist das Testmodell 8 eine Kombination aller Entitäten, mit denen die Lüftersteuerung im realen Betrieb in Verbindung steht. Insofern ist das Testmodell 8 ein vollständiges Umgebungsmodell der Lüftersteuerung, auch als Streckenmodell bezeichnet. Im vorliegenden Beispiel ist das Testmodell 8 die Kombination eines Lüfters, eines entweder im Lüfter angeordneten oder separat angeordneten Temperatursensors sowie eines Ein/Aus-Schalters.

Das Testmodell 8 hat eine erste Kommunikationsschnittstelle 82, eine zweite Kommunikationsschnittstelle 84 und eine dritte Kommunikationsschnittstelle 86. Die erste Kommunikationsschnittstelle 82 des Testmodells 8 ist mit der ersten Kommunikationsschnittstelle 102 des Basistestmodells 100 verbunden und eingerichtet, den oben beschriebenen Leistungswert zu empfangen. Die zweite Kommunikationsschnittstelle 84 des Testmodells 8 ist mit der zweiten Kommunikationsschnittstelle 104 des Basistestmodells 100 verbunden und zur Ausgabe des oben beschriebenen Temperaturwerts eingerichtet. Die dritte Kommunikationsschnittstelle 86 des Testmodells 8 ist mit der dritten Kommunikationsschnittstelle 106 des Basistestmodells 100 verbunden und zur Ausgabe des oben beschriebenen Ein/Aus-Werts eingerichtet.

Durch das Bereitstellen des Basistestmodells 100 der Lüftersteuerung und des Testmodells 8 der Umgebung der Lüftersteuerung kann zu einem sehr frühen Stadium der Entwicklung der Lüftersteuerung ein rein rechnergestützter Basistest durchgeführt werden, bei dem die Funktionalität der Lüftersteuerung auf Software-Ebene getestet und analysiert werden kann. Dabei gelten für die Kommunikation zwischen dem Basistestmodell 100 der Lüftersteuerung und dem Testmodell 8 der Umgebung der Lüftersteuerung folgende Konventionen. Der Leistungswert hat einen Wert zwischen 0 und 1, wobei der momentane konkrete Wert zwischen diesen Grenzen anzeigt, wie stark der Lüfter laufen soll. Der Temperaturwert repräsentiert die momentane Temperatur als Gleitkommazahl in °C. Der Ein/Aus-Wert ist ein binärer Wert und gibt an, ob die Lüftung momentan komplett ausgeschaltet ist oder ob sie laufen soll.

Figur 2 zeigt ein Testgerät 2, in dem vorliegenden Fall ein HIL-Simulator, an den eine gerätemäßige Implementierung 200 der Lüftersteuerung, für die in Figur 1 das Basistestmodell 100 gezeigt ist, angeschlossen ist.

Die gerätemäßige Implementierung 200 der Lüftersteuerung, auch als Lüftersteuerung 200 bezeichnet, ist eine Vorrichtung, die zu einem recht späten Stadium der Entwicklung vorliegt. Insbesondere handelt es sich bei der Lüftersteuerung 200 um eine Vorrichtung, die einen voll funktionsfähigen Prototypen der später serienmäßig verwendeten Lüftersteuerung darstellt. Die Lüftersteuerung 200 hat sechs Anschlüsse, nämlich einen ersten Anschluss 202, einen zweiten Anschluss 204, einen dritten Anschluss 206, einen vierten Anschluss 208, einen fünften Anschluss 210 und einen sechsten Anschluss 212. Über diese sechs Anschlüsse findet die physikalische Signalübertragung der Lüftersteuerung 200 sowie die Versorgung mit elektrischer Leistung statt. Der erste Anschluss 202, der zweite Anschluss 204 und der dritte Anschluss 206 dienen der Kommunikation mit der Umgebung der Lüftersteuerung sowie der Versorgung des Lüfters mit elektrischer Energie, wie unten detailliert erläutert wird. Der vierte Anschluss 208 dient dabei als Referenz-Anschluss. Über den fünften Anschluss 210 wird die Lüftersteuerung 200 mit elektrischer Energie in Form einer Betriebsspannung versorgt. An dem sechsten Anschluss 212 liegt Masse bzw. Null-Potential an. Über den ersten bis vierten Anschluss 202, 204, 206, 208 ist die Lüftersteuerung 200 mit dem Testgerät 2 verbunden.

Das Testgerät 2 weist eine Eingabe/Ausgabe-Schnittstelle 4 auf. Im Allgemeinen haben Testgeräte wie der hier gezeigte HIL-Simulator eine Vielzahl von Anschlüssen als Teil der Eingabe/Ausgabe-Schnittstelle. Der Übersichtlichkeit halber sind in Figur 2 nur die sechs verwendeten Anschlüsse der Eingabe/Ausgabe-Schnittstelle gezeigt, nämlich der erste Anschluss 40a, der zweite Anschluss 40b, der dritte Anschluss 40c, der vierte Anschluss 40d, der fünfte Anschluss 40e und der sechste Anschluss 40f der Eingabe/Ausgabe-Schnittstelle 4. Der erste Anschluss 40a ist mit dem ersten Anschluss 202 der Lüftersteuerung 200 verbunden. Der dritte Anschluss 40c ist mit dem zweiten Anschluss 204 der Lüftersteuerung 200 verbunden. Der fünfte Anschluss 40e ist mit dem dritten Anschluss 206 der Lüftersteuerung 200 verbunden. Der zweite Anschluss 40b, der vierte Anschluss 40d und der sechste Anschluss 40f sind mit dem vierten Anschluss 208 der Lüftersteuerung 200 verbunden.

Weiterhin enthält das Testgerät 2 das Testmodell 8 der Umgebung der Lüftersteuerung, wie bzgl. Figur 1 beschrieben. Wiederum hat das Testmodell 8 der Umgebung der Lüftersteuerung die erste Kommunikationsschnittstelle 82, die zweite Kommunikationsschnittstelle 84 und die dritte Kommunikationsschnittstelle 86.

Die Eingabe/Ausgabe-Schnittstelle 4 ist mit dem Testmodell 8 der Umgebung der Lüftersteuerung durch eine Mehrzahl von Verbindungen verbunden, die in ihrer Gesamtheit mit der Bezugsziffer 6 bezeichnet sind. Die Verbindungen umfassen eine erste Verbindung 6a, eine zweite Verbindung 6b und eine dritte Verbindung 6c, welche jeweils eine Eingabe/Ausgabe-Funktion und ein Skalierungsmodul aufweisen. Die erste Verbindung 6a weist eine erste Eingabe/Ausgabe-Funktion 60 und ein erstes Skalierungsmodul 70 auf. Die erste Eingabe/Ausgabe-Funktion 60 ist mit dem ersten Anschluss 40a und dem zweiten Anschluss 40b der Eingabe/Ausgabe-Schnittstelle verbunden. Weiterhin hat die erste Eingabe/Ausgabe-Funktion 60 zwei Kommunikationsschnittstellen 60a und 60b, über die sie mit dem ersten Skalierungsmodul 70 kommuniziert, welches wiederum mit der ersten Kommunikationsschnittstelle 82 des Testmodells 8 kommuniziert. Die zweite Verbindung 6b hat eine zweite Eingabe/Ausgabe-Funktion 62 und ein zweites Skalierungsmodul 72. Die zweite Eingabe/Ausgabe-Funktion 62 ist mit dem dritten Anschluss 40c und dem vierten Anschluss 40d der Eingabe/Ausgabe-Schnittstelle 4 verbunden und kommuniziert über eine Kommunikationsschnittstelle 62a mit dem zweiten Skalierungsmodul 72, welches wiederum mit der zweiten Kommunikationsschnittstelle 84 des Testmodells 8 verbunden ist. Die dritte Verbindung 6c weist eine dritte Eingabe/Ausgabe-Funktion 64 und ein drittes Skalierungsmodul 74 auf. Die dritte Eingabe/Ausgabe-Funktion 64 ist mit dem fünften Anschluss 40e und dem sechsten Anschluss 40f der Eingabe/Ausgabe-Schnittstelle 4 verbunden und kommuniziert mit dem dritten Skalierungsmodul 74 über eine Kommunikationsschnittstelle 64a, wobei das dritte Skalierungsmodul 74 mit der dritten Kommunikationsschnittstelle 86 des Testmodells 8 verbunden ist. Weiterhin ist die erste Eingabe/Ausgabe-Funktion 60 mit einer Lastschaltung 50 verbunden.

Das Konfigurieren der Verbindungen 6 auf Basis des in Figur 1 gezeigten und oben beschriebenen Basistestmodells 100 der Lüftersteuerung gemäß einer beispielhaften Ausführungsform des erfindungsgemäßen Verfahrens wird im Folgenden beschrieben. Wie oben bzgl. Figur 1 erwähnt, ist die Konvention für die Kommunikation zwischen dem Basistestmodell 100 und dem Testmodell 8 folgendermaßen. Der Leistungswert wird durch einen Wert zwischen 0 und 1 übermittelt. Der Temperaturwert wird durch eine Gleitkommazahl in °C übermittelt. Der Ein/Aus-Wert wird durch einen binären Wert übermittelt. Diese Konventionen, welche auch als Kommunikationsanforderungen bezeichnet werden, werden von dem Verfahren zum Verbinden der Eingabe/Ausgabe-Schnittstelle aus dem Basistestmodell 100 extrahiert.

Weiterhin werden die folgenden Kommunikationsanforderungen aus dem Basistestmodell 100 extrahiert: Der Leistungswert darf eine maximale Abweichung von 0,05 von dem gewünschten Wert haben. Der Temperaturwert hat einen Wertebereich zwischen -15 °C und 70 °C. Der Temperaturwert muss mit einer Genauigkeit von 0,1°C vorliegen. Der Temperaturwert muss mindestens ein Mal pro Sekunde übertragen werden. Der Ein/Aus-Wert muss mindestens zehn Mal pro Sekunde übertragen werden. Bei dem Leistungswert entspricht der Wert 1 einer Leistungsabgabe der Lüftersteuerung an den Lüfter von 200 Watt.

Auf Basis dieser Kommunikationsanforderungen legt die beispielhafte Ausführungsform des erfindungsgemäßen Verfahrens mehrere Merkmale der physikalischen Signalübertragung fest, wobei diese Merkmale so gewählt werden, dass die Kommunikationsanforderungen erfüllt werden. Die beispielhafte Ausführungsform des erfindungsgemäßen Verfahrens legt fest, dass die von der Lüftersteuerung an den Lüfter zur Verfügung gestellte Leistung als ein Pulsweiten-moduliertes Spannungssignal zur Verfügung gestellt wird. Dabei pendelt die Spannung zwischen einem Wert von 12V und einem Wert von 0V, wobei der Auslastungsgrad, d.h. das Verhältnis der Länge des Vorliegens der Spannung von 12V im Vergleich zur Gesamtlänge einer Periode, auch als duty cycle bezeichnet, dem Leistungswert entspricht. Weiterhin legt das Verfahren fest, dass der Temperaturwert durch ein Spannungssignal übertragen wird, wobei die Höhe der Spannung zwischen 0V und 10V ist, wobei 0V einem Temperaturwert von -15 °C entsprechen und 10V einem Temperaturwert von 70°C entsprechen. Weiterhin legt das Verfahren fest, dass die Übertragung des Ein/Aus-Wertes ebenfalls per Spannung übertragen wird, wobei eine Spannung von größer 2,5V den Ein-Zustand kodiert und eine Spannung von kleiner 2,5V den Aus-Zustand kodiert. Somit hat das Verfahren die Merkmale der physikalischen Signalübertragung auf Basis der Kommunikationsanforderungen festgelegt.

Wie oben im Allgemeinen beschrieben, kann das Verfahren diese Festlegungen rein auf Basis der Kommunikationsanforderungen und vorhandener Korrelationen bzw. Auswahl-Algorithmen festlegen. Es ist aber auch möglich, dass das Verfahren diese Festlegungen im Zusammenspiel mit einer externen Instanz, wie z.B. einem Benutzer, festlegt. Der Benutzer kann dabei sein Wissen über geeignete Merkmale der physikalischen Signalübertragung und/oder sein Wissen über die gerätemäßige Implementierung 200 des Steuergeräts einfließen lassen. Dabei kann es auch gemischte Verfahren geben, wobei einzelne Merkmale vollautomatisch festgelegt werden, während andere Merkmale interaktiv durch einen Benutzer festgelegt werden. Auch ist es möglich, dass das Verfahren alle Merkmale festlegt, welche aber dann von dem Benutzer abgeändert werden können.

Auf der Basis der oben diskutierten Kommunikationsanforderungen und der oben diskutierten festgelegten Merkmale der physikalischen Signalübertragung konfiguriert das Verfahren nun die Verbindungen 6 in dem Testgerät 2. Die erste Verbindung 6a wird folgendermaßen konfiguriert. Es wird die erste Eingabe/Ausgabe-Funktion 60 erstellt, die zur Verarbeitung eines eingehenden Pulsweiten-modulierten Signals eingerichtet ist. Die erste Eingabe/Ausgabe-Funktion 60 analysiert das eingehende Signal hinsichtlich Frequenz und duty-cycle und leitet das Signal an die Lastschaltung 50 weiter, wo die elektrische Energie des Eingangssignals verbraucht wird, z.B. mittels eines oder mehrerer Lastwiderstände. Die Information über die Frequenz und den duty cycle des Pulsweiten-modulierten Signals gibt die erste Eingabe/Ausgabe-Funktion über die Kommunikationsschnittstellen 60a bzw. 60b an das erste Skalierungsmodul 70 ab, welches auch im Rahmen der Konfiguration durch das Verfahren erstellt wird. Das Skalierungsmodul 70 errechnet daraus einen Leistungswert zwischen 0 und 1, wie ihn das Testmodell 8 erwartet, und gibt diesen an die erste Kommunikationsschnittstelle 82 des Testmodells 8 aus.

Die zweite Verbindung 6b wird folgendermaßen konfiguriert. Es wird die zweite Eingabe/Ausgabe-Funktion 62 erstellt, die eingerichtet ist, die Informationen über einen Spannungswert an der Kommunikationsschnittstelle 62a zu erhalten und eine dementsprechende Spannung zwischen dem dritten Anschluss 40c und dem vierten Anschluss 40d der Eingabe/Ausgabe-Schnittstelle 4 auszugeben. Weiterhin wird das zweite Skalierungsmodul 72 erstellt, das aus dem von dem Testmodell 8 ausgegebenen Temperaturwert zwischen -15°C und 70°C einen Spannungswert zwischen 0V und 10V anhand einer linearen Funktion errechnet und diesen an die zweite Eingabe/Ausgabe-Funktion 62 weitergibt.

Die dritte Verbindung 6c wird folgendermaßen konfiguriert. Es wird eine dritte Eingabe/Ausgabe-Funktion 64 erstellt, die eingerichtet ist, entweder einen Wert von 5V oder einen Wert von 0V zwischen dem fünften Anschluss 40e und dem sechsten Anschluss 40f der Eingabe/Ausgabe-Schnittstelle 4 auszugeben. Weiterhin wird ein drittes Skalierungsmodul 74 erstellt, das im vorliegenden Fall den Ein/Aus-Wert, wie er von der dritten Kommunikationsschnittstelle 86 des Testmodells 8 als binärer Wert ausgegeben wird, als binären Wert an die Kommunikationsschnittstelle 64a der dritten Eingabe/Ausgabe-Funktion 64 weiterleitet. Da das dritte Skalierungsmodul 74 im Kontext eines binären Werts rein für die Weitergabe des Werts verantwortlich ist, kann dieses auch entfallen. Im allgemeinen ist es auch möglich, dass die Skalierungsfunktionalität der Skalierungsmodule in die jeweiligen Eingabe/Ausgabe-Funktionen integriert ist.

Nach Konfiguration der Verbindungen besteht eine funktionierende Signalübertragungskette zwischen der gerätemäßigen Implementierung 200 der Lüftersteuerung und dem Testmodell 8 der Umgebung der Lüftersteuerung, so dass die Lüftersteuerung 200 ausgiebig getestet werden kann. Zu diesem Zweck weist das Testgerät 2 die Funktionalität auf, durch geeignete Signale, Impulse und Anstöße das Verhalten des Testmodells 8 und der Lüftersteuerung 200 in verschiedensten Betriebssituationen zu beobachten und zu analysieren.

Für die Konfiguration einer RCP-Simulation kann das Verfahren in analoger Weise ausgeführt werden. In diesem Fall wird das Testgerät an eine gerätemäßige Umgebung der Lüftersteuerung angeschlossen. Insbesondere kann das Testgerät mit seiner Eingabe/Ausgabe-Schnittstelle an einen Lüfter sowie an einen Bedienschalter für den Lüfter sowie an einen Temperatursensor angeschlossen sein. Das in dem Testgerät vorhandene Modell kann das Basistestmodell 100 oder ein weiterentwickeltes Modell der Lüftersteuerung sein. Auf Basis der in dem Basistestmodell 100 vorhandenen Information können geeignete Verbindungen zwischen dem Modell der Lüftersteuerung und der Eingabe/Ausgabe-Schnittstelle erstellt werden, so dass eine funktionierende Signalübertragungskette zwischen dem Modell der Lüftersteuerung und der Umgebung der Lüftersteuerung entsteht. Die konfigurierten Verbindungen können den in Figur 2 gezeigten und oben beschriebenen Verbindungen im Wesentlichen entsprechen, wobei aber die Signalübertragungsrichtung umgekehrt ist.

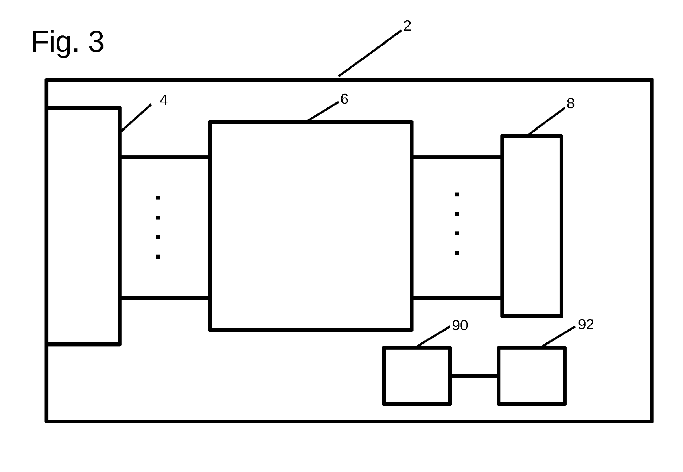

In Figur 3 ist eine weitere beispielhafte Ausführungsform eines Testgeräts 2 gemäß einer Ausführungsform der Erfindung gezeigt. Die oben beschriebenen Elemente Eingabe/Ausgabe-Schnittstelle 4, Verbindungen 6 und Testmodell 8 sind vereinfacht als grobe Funktionsblöcke dargestellt. Im Vergleich zu Figur 2 sind in Figur 3 zusätzlich ein Prozessor 90 und ein Speicher 92 dargestellt. Das oben beschriebene Verfahren kann auf dem Prozessor 90 ausgeführt werden. Die Instruktionen für das Verfahren und die Entscheidungsregeln bzw. -algorithmen für die Merkmale der physikalischen Signalübertragung können in dem Speicher 92 abgelegt sein. Der Prozessor 90 kann auf den Speicher 92 zugreifen und auf Basis der im Speicher 92 vorhandenen Information das Verfahren ausführen.

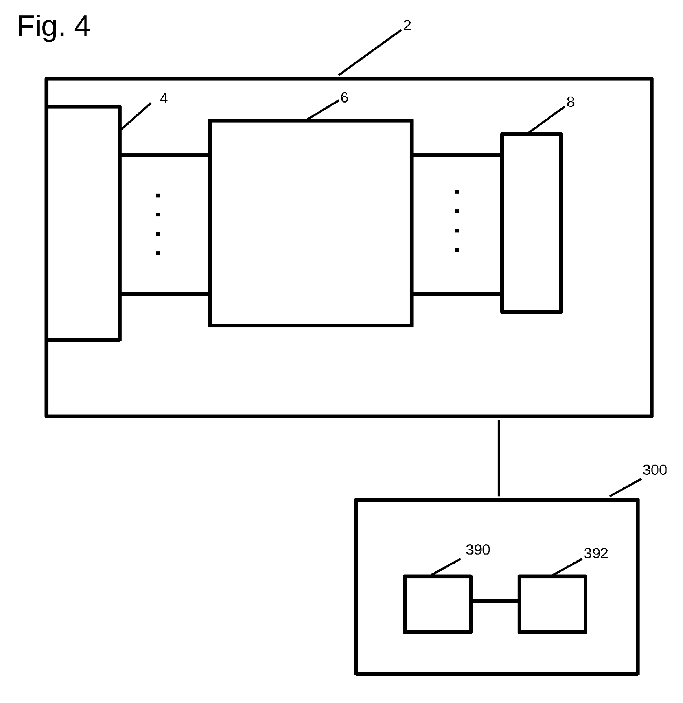

Eine Abwandlung ist in Figur 4 gezeigt, wo ein Konfigurations-Rechner 300 an das Testgerät 2 angeschlossen ist. Der Konfigurations-Rechner 300 hat einen Prozessor 390 und einen Speicher 392. Er kann das oben beschriebene Verfahren von außerhalb des Testgeräts durchführen und dabei über die Verbindung zwischen dem Konfigurations-Rechner 300 und dem Testgerät 2 die Verbindungen 6 in dem Testgerät 2 konfigurieren.

Es wird betont, dass sowohl das Testgerät 2 als auch der Konfigurations-Rechner 300 Eingabe- bzw. Ausgabevorrichtungen aufweisen kann, wie z.B. einen Monitor, eine Tastatur, ein Touch-Pad und/oder eine Maus, so dass ein Benutzer auf das Verfahren Einfluss nehmen kann, wie oben detailliert beschrieben.

Obwohl die Erfindung mit Bezug auf beispielhafte Ausführungsformen beschrieben worden ist, ist es für einen Fachmann ersichtlich, dass verschiedene Änderungen vorgenommen und Äquivalente verwendet werden können, ohne den Bereich der Erfindung zu verlassen. Die Erfindung soll nicht durch die beschriebenen spezifischen Ausführungsformen beschränkt sein. Vielmehr enthält sie alle Ausführungsformen, die unter die angehängten Patentansprüche fallen.

## Patentansprüche

1. Verfahren zum Verbinden einer Eingabe/Ausgabe-Schnittstelle (4) eines für die Steuergerätentwicklung eingerichteten Testgeräts (2) mit einem in dem Testgerät vorhandenen Modell (8) eines technischen Systems unter Verwendung eines bereits vorhandenen Basistestmodells (100) eines Steuergeräts, wobei die Eingabe/Ausgabe-Schnittstelle zum Anschluss einer gerätemäßigen Implementierung (200) des Steuergeräts oder zum Anschluss eines zu steuernden technischen Systems ausgebildet ist und das mit der Eingabe/Ausgabe-Schnittstelle zu verbindende Modell ein Testmodell (8) des zu steuernden technischen Systems oder ein Testmodell des Steuergeräts ist, wobei das Verfahren die folgenden Schritte aufweist:
Zugreifen auf das bereits vorhandene Basistestmodell des Steuergeräts, wobei das Basistestmodell für einen rein rechnergestützten Basistest ausgelegt ist,
Extrahieren von mindestens einer Kommunikationsanforderung aus dem Basistestmodell des Steuergeräts,
auf der Basis der mindestens einen Kommunikationsanforderung, Festlegen von mindestens einem Merkmal einer physikalischen Signalübertragung, die für die Kommunikationsanforderung geeignet ist, und
Konfigurieren von mindestens einer Verbindung (6) zwischen der Eingabe/Ausgabe-Schnittstelle des Testgeräts und dem in dem Testgerät vorhandenen Modell, die die physikalische Signalübertragung über die Eingabe/Ausgabe-Schnittstelle gemäß dem mindestens einen Merkmal bei Erfüllung der mindestens einen Kommunikationsanforderung ermöglicht.

2. Verfahren nach Anspruch 1, wobei der Schritt des Festlegens von mindestens einem Merkmal einer physikalischen Signalübertragung die folgenden Schritte aufweist:
Ausgeben der mindestens einen Kommunikationsanforderung an eine externe Instanz, und
Empfangen einer Angabe von der externen Instanz, wobei die Angabe das mindestens eine, mit der mindestens einen Kommunikationsanforderung assoziierte Merkmal definiert.

3. Verfahren nach Anspruch 2, wobei die externe Instanz ein Benutzer oder ein externes Konfigurationsprogramm ist.

4. Verfahren nach einem der vorhergehenden Ansprüche, wobei der Schritt des Festlegens von mindestens einem Merkmal einer physikalischen Signalübertragung die folgenden Schritte aufweist:
Zugreifen auf einen Datensatz, der Korrelationen zwischen Kommunikationsanforderungen und Merkmalen physikalischer Signalübertragungen enthält, und
Auswählen des mindestens einen Merkmals der physikalischen Signalübertragung auf Basis der Korrelationen.

5. Verfahren nach einem der vorhergehenden Ansprüche, wobei der Schritt des Konfigurierens der mindestens einen Verbindung zwischen der Eingabe/Ausgabe-Schnittstelle des Testgeräts und dem in dem Testgerät vorhandenen Modell die folgenden Schritte aufweist:
Ausgeben von mehreren möglichen Verbindungsvorschlägen zwischen der Eingabe/Ausgabe-Schnittstelle des Testgeräts und dem in dem Testgerät vorhandenen Modell zur Auswahl an einen Benutzer, und
Empfangen der Auswahl der mindestens einen Verbindung von dem Benutzer.

6. Verfahren nach einem der vorhergehenden Ansprüche, wobei die Eingabe/Ausgabe-Schnittstelle des Testgeräts eine Mehrzahl von Anschlüssen (40a, 40b, 40c, 40d, 40e, 40f) aufweist und wobei das Testgerät eine Mehrzahl von Eingabe/Ausgabe-Funktionen (60, 62, 64) aufweist, die mit dem in dem Testgerät vorhandenen Modell und mit der Eingabe/Ausgabe-Schnittstelle verbunden sind, wobei der Schritt des Konfigurierens der mindestens einen Verbindung zwischen der Eingabe/Ausgabe-Schnittstelle des Testgeräts und dem in dem Testgerät vorhandenen Modell die folgenden Schritte aufweist:
Auswählen von mindestens einem Anschluss der Mehrzahl von Anschlüssen, und
Parametrisieren von mindestens einer Eingabe/Ausgabe-Funktion der Mehrzahl von Eingabe/Ausgabe-Funktionen, wobei die mindestens eine Eingabe/Ausgabe-Funktion den mindestens einen Anschluss steuert und wobei das Parametrisieren die mindestens eine Eingabe/Ausgabe-Funktion so einrichtet, dass sie während des Testens die physikalische Signalübertragung über die Eingabe/Ausgabe-Schnittstelle gemäß dem mindestens einen Merkmal bei Erfüllung der mindestens einen Kommunikationsanforderung ausführt.

7. Verfahren nach einem der vorhergehenden Ansprüche, wobei die mindestens eine Kommunikationsanforderung ein Parameter oder ein Parameter-Set aus der Gruppe, bestehend aus Datentyp, Datenbreite, physikalischer Einheit, Anschluss-Typ, Übertragungshäufigkeit, Latenzzeit, Wertebereich und Wertegenauigkeit, ist.

8. Verfahren nach einem der vorhergehenden Ansprüche, wobei das mindestens eine Merkmal der physikalischen Signalübertragung aus der Gruppe, bestehend aus Signalübertragung per Spannung, Signalübertragung per Strom, physikalischer Spannungsbereich, physikalischer Strombereich, Digitalübertragung, Analogübertragung, Übertragung per Pulsweitenmodulation, Übertragung per Pulsfrequenzmodulation, Übertragung per Datenbus, Datenübertragungsrate, ist.

9. Verfahren nach einem der vorhergehenden Ansprüche, wobei der Schritt des Extrahierens von mindestens einer Kommunikationsanforderung des zu testenden Steuergeräts aus dem Basistestmodell das Extrahieren aller Kommunikationsanforderungen des zu testenden Steuergeräts umfasst und wobei der Schritt des Festlegens von mindestens einem Merkmal einer physikalischen Signalübertragung das Festlegen einer Mehrzahl von Merkmalen der physikalischen Signalübertragung umfasst, wobei die Mehrzahl von Merkmalen alle Kommunikationsanforderungen abdeckt.

10. Verfahren nach Anspruch 9, wobei der Schritt des Konfigurierens der mindestens einen Verbindung zwischen der Eingabe/Ausgabe-Schnittstelle des Testgeräts und dem in dem Testgerät vorhandenen Modell das Konfigurieren einer Mehrzahl von Verbindungen zwischen der Eingabe/Ausgabe-Schnittstelle des Testgeräts umfasst und ferner den folgenden Schritt aufweist:
Zusammenfassen von mindestens zwei Verbindungen, die sich einen bestimmten Anschluss der Eingabe/Ausgabe-Schnittstelle teilen, durch Definieren einer Zugriffsordnung auf den bestimmten Anschluss.

11. Verfahren nach einem der vorhergehenden Ansprüche,
wobei das Testgerät (2) ein Hardware-in-the-Loop-Simulationsgerät ist und wobei die Eingabe/Ausgabe-Schnittstelle zum Anschluss der gerätemäßigen Implementierung (200) des Steuergeräts ausgebildet ist und das mit der Eingabe/Ausgabe-Schnittstelle zu verbindende Modell das Testmodell (8) des zu steuernden technischen Systems ist, oder
wobei das Testgerät ein Rapid-Control-Prototyping-Testgerät ist und wobei die Eingabe/Ausgabe-Schnittstelle zum Anschluss des zu steuernden technischen Systems ausgebildet ist und das mit der Eingabe/Ausgabe-Schnittstelle zu verbindende Modell das Testmodell des Steuergeräts ist.

12. Verfahren nach einem der Ansprüche 1 bis 10, wobei das Testgerät ein Rapid-Control-Prototyping-Testgerät ist und wobei die Eingabe/Ausgabe-Schnittstelle zum Anschluss des zu steuernden technischen Systems ausgebildet ist und das mit der Eingabe/Ausgabe-Schnittstelle zu verbindende Modell das Testmodell des Steuergeräts ist, wobei das Testmodell des Steuergeräts des Rapid-Control-Prototyping-Testgeräts dem bereits vorhandenen Basistestmodell entspricht.

13. Verfahren nach einem der vorhergehenden Ansprüche, wobei der Schritt des Konfigurierens von mindestens einer Verbindung zwischen der Eingabe/Ausgabe-Schnittstelle des Testgeräts und dem in dem Testgerät vorhandenen Modell den folgenden Schritt aufweist:
Konfigurieren von mindestens einer fehlerbehafteten Verbindung zwischen der Eingabe/Ausgabe-Schnittstelle des Testgeräts und dem in dem Testgerät vorhandenen Modell, wobei die mindestens eine fehlerbehaftete Verbindung eingerichtet ist, Übertragungsfehler und/oder Störeinflüsse, wie z.B. einen Kabelbruch, einen Kurzschluss, elektromagnetische Störfelder, Umwelteinflüsse, zu simulieren.

14. Computerprogrammprodukt sowie Computerprogramm zur Ausführung eines Verfahrens zum Verbinden einer Eingabe/Ausgabe-Schnittstelle eines für die Steuergerätentwicklung eingerichteten Testgeräts, das so ausgebildet ist, dass bei Ausführung des Computerprogramms ein Verfahren gemäß einem der vorhergehenden Ansprüche ausgeführt wird.

15. Für die Steuergerätentwicklung eingerichtetes Testgerät (2), aufweisend:
eine Eingabe/Ausgabe-Schnittstelle (4) zum Anschluss einer gerätemäßigen Implementierung (200) eines Steuergeräts oder zum Anschluss eines zu steuernden technischen Systems, und
ein Testmodell (8) des zu steuernden technischen Systems oder ein Testmodell des Steuergeräts,
wobei das Testgerät eingerichtet ist, ein Verfahren gemäß einem der Ansprüche 1 bis 13 auszuführen.
